# EUROPEAN PATENT SPECIFICATION

(11) **EP 4 001 970 B1**
(45) Date of publication and mention of the grant of the patent: **19.08.2026**
(21) Application number: 20306436.5
(22) Date of filing: 24.11.2020
(51) Int. Cl.: G01T 1/26, G01T 1/29, G01T 7/00, H01J 37/304

(54) **RADIATION DETECTOR**
STRAHLUNGSDETEKTOR
DÉTECTEUR DE RAYONNEMENTS

(43) Date of publication of application: 25.05.2022
(73) Proprietor: Commissariat à l'Energie Atomique et aux Energies Alternatives, 75015 Paris (FR)
(72) Inventor: POMORSKI, Michal, 91140 VILLEBON SUR YVETTE (FR)
(74) Representative: Ipsilon

(56) References cited:
- JP-A- H08 297 166
- US-A- 4 833 328
- OLIVERO P ET AL: "Focused ion beam fabrication and IBIC characterization of a diamond detector with buried electrodes", NUCLEAR INSTRUMENTS & METHODS IN PHYSICS RESEARCH. SECTION B: BEAM INTERACTIONS WITH MATERIALS AND ATOMS, vol. 269, no. 20, 26 February 2011 (2011-02-26), pages 2340 - 2344, XP028305477, ISSN: 0168-583X, [retrieved on 20110226], DOI: 10.1016/J.NIMB.2011.02.021

## Description

### Field of the invention

The present invention relates to a method for manufacturing a radiation detector and to a detector obtained with such a method.

### Background of the invention

Many beamlines at modern light-source facilities are working with X-ray beams focused down to a few tenths of a micron, and record X-ray data within a millisecond speed. In such beamlines, the stability of the beam is crucial for the success of experiments, and fast diagnostics are needed to precisely regulate the position of the X-ray beam. For this reason, X-Ray beam position monitors (XBPM), or position sensitive detectors (PSD) are permanently mounted in the beamlines.

It is known to detect radiation and/or monitor X-Ray beam position using a single crystal chemical vapor deposited (scCVD) diamond. ScCVD diamond is a popular and well-established sensor material because of its excellent radiation and mechanical resistance properties. The published paper *"*X-Ray position-sensitive duo-lateral diamond detectors at SOLEIL" (Desjardins et al., Journal of Synchrotron Radiation. 2018 Mar 1;25(2):399-406.) reports the excellent performance of a radiation detector based on scCVD diamond substrate with diamond-like carbon surface electrodes when operated under high vacuum conditions. However, it has been observed that the surface electrodes of such detectors suffer substantial damage when operated under ambient or low vacuum conditions, rendering the detectors non-operational. Since those conditions are prevalent in many beamlines, there is a need to address the issue of surface electrode damage.

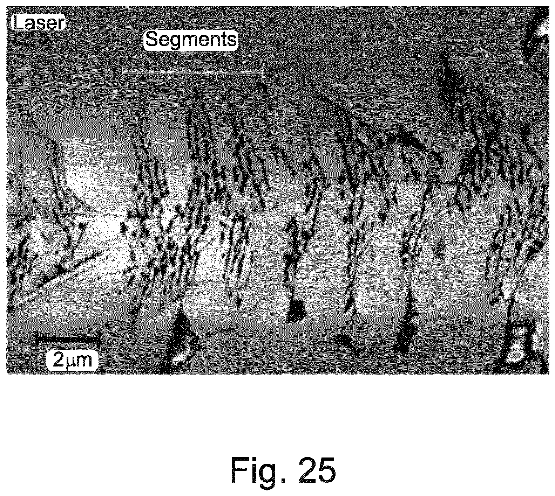

In the papers *"*A novel detector with graphitic electrodes in CVD diamond" (Oh et. Al., Diamond and related materials. 2013 Sep 1;38:9-13) and "A single-crystal diamond X-ray pixel detector with embedded graphitic electrodes" (Bloomer et al., Journal of Synchrotron Radiation. 2020 May 1;27(3)), a novel electrode geometry is described where graphitic microchannels, or "wires", are embedded within the bulk diamond and acting as electrodes. The electrodes are formed within the diamond substrate using a laser induced graphitization technique, the wires being "pulled" one after the other. This method is relatively time consuming and the electrodes may exhibit as shown in Figure 25 cracks and are not homogeneous, leading to leakage current issues, making the position detecting or position monitoring of the radiation somewhat unreliable.

US 4 833 328 discloses a detector having contacts formed by implantation of carbon ions in a diamond. In OLIVERO P ET AL: "Focused ion beam fabrication and IBIC characterization of a diamond detector with buried electrodes", NUCLEAR INSTRUMENTS & METHODS IN PHYSICS RESEARCH. SECTION B: BEAM INTERACTIONS WITH MATERIALS AND ATOMS, vol. 269, no.20, 26 February 2011 (2011-02-26), pages 2340-2344, a radiation detector and manufacturing method therefor are shown, comprising a substrate of a single-crystal diamond, forming at least one first graphitic electrode at least partially embedded within the substrate by ion implantation, connecting the first electrode with a least one electrical terminal. The document further shows a second electrode. A variable-thickness mask process allows for modulation of a penetration depth of the ions forming the electrodes. Graphitic electrodes are formed by annealing of ion-induced damage regions exceeding a damage threshold, while other regions recover from the damage to a highly resistive diamond phase, leaving graphitic electrodes embedded (buried) in an insulating diamond matrix. Charge collection efficiencies are mapped within the X-Y plane.

There remains a need for improving the manufacturing of radiation detectors and for providing detectors which are reliable and exhibit relatively good resistance to radiation induced damage under various vacuum conditions.

### Summary

The present invention aims to remedy to all or part of the deficiencies of the prior art mentioned above and embodiments of the invention relate to a method for manufacturing a radiation detector as defined in claim 1.

Because the first graphitic electrode is at least partially embedded within the substrate, it is better protected from beam-induced radiation or chemical damage.

By "embedded" it is meant that the graphitic electrode lies within the substrate; as encompassed by the appended claims, it is buried, i.e. covered by diamond substrate on both sides in thickness direction, or as an example, not encompassed by the claims, not buried, i.e. the graphitic electrode emerges from the substrate.

The second graphitic electrode preferably acts as a bias electrode and is preferentially formed near the bottom part of the substrate. The first graphitic electrode is formed beneath the top surface of the substrate. Both the bottom and top surfaces of the substrate are exposed to the incident radiation since the detector works in transmission mode. By top surface, it is meant the horizontal face of the detector facing the light source.

### Substrate

The substrate in the present invention comprises a single-crystal diamond. Preferentially, a synthetic single-crystal diamond grown by chemical vapor deposition (CVD) is used, for example a type IIa single-crystal CVD diamond. scCVD diamond is commercially available from known providers, for example the company ElementSix.

In preferred embodiments, the diamond substrate undergoes cleaning and preparation steps prior to the ion implantation. The substrate is for example cleaned using a hot acid treatment such as sulfuric acid combined with potassium nitrate.

The substrate preferably has two opposite planar faces that constitute the top and bottom faces thereof. The lateral faces may be perpendicular to the top and bottom faces or may extend obliquely. The substrate may have two pairs of opposite lateral faces, a first pair of opposite faces each being planar and both being convergent towards the bottom face, and the second pair of opposite faces each being planar and both being convergent towards the top face.

A thickness of the substrate may range from 0.001 to 1mm.

The area of the top or bottom face may range from 1 mm² to 100 mm², preferentially from 1mm² to 25mm².

### Ion implantation process

Local diamond graphitization at a desired depth is obtained by ion implantation. Ion implantation is already used for forming biosensors electrodes through the fabrication of graphitic micro channels embedded in a sublayer within a diamond substrate, as described in the paper_ *"*Development and Characterization of a Diamond-Insulated Graphitic Multi Electrode Array Realized with Ion Beam Lithography"(Picollo et al., Sensors. 2015 Jan;15(1):515-28).

Most of the changes to the diamond induced by ion implantation takes place at the end of the ion track, usually within a layer of a dozen to hundreds of nanometers thickness. The diamond "cap" overlying the implantation region is left relatively undamaged, as the graphitization threshold is not been attained in this region.

It is therefore possible to control the thickness of the implanted layer and the depth at which it is implanted within the substrate by selecting the type of ion, and the flux and kinetic energy of the radiation during ion implantation.

In preferred embodiments of the present invention, helium or carbon ions are implanted within the diamond substrate at a preferential energy ranging from hundreds of keV to several MeV. Moreover, the resistivity of the implanted layers may be tuned by varying the fluence at which ion implantation is performed.

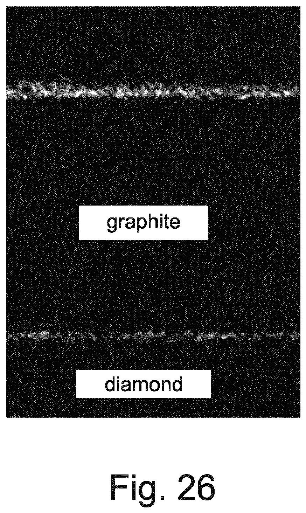

One advantage of forming the electrodes by ion implantation is that they comprise graphitic layers that are are somewhat continuous, homogeneous and two-dimensional in nature, which greatly reduces the risk of detector leakage current and mechanical damage to the crystal (cracking). One can see in the picture of Figure 26 the absence of cracks in the graphitic electrode layer by contrast to Figure 25. Moreover, the strain induced in the diamond bulk during ion implantation is homogenously distributed in contrary to the laser approach.

In some embodiments, the electrodes are resistive. The resistance of the electrodes may range from a few kOhms to a few hundreds of kOhms.

The graphitic electrodes formed by ion implantation may be produced in batch, which greatly improves the cost and speed of the manufacturing process compared to laser graphitization.

### Masking and patterning technique

Masks may be used to form the electrodes at a desired depth and with a desired shape.

The first electrode may have a shape selected among polygonal, preferably rectangular or square, circular sector, preferably quadrant, or stripe-like. The use of a hard mask combined or not with photolithographic technique is preferred for patterns with small gaps between two adjacent separate electrodes, such a quadrant electrodes or stripe-like electrodes.

The surface of the substrate may be at least partially covered with a masking material prior to the ion implantation, the masking material preventing at least partially the ions from penetrating into the substrate during ion implantation and/or modifying the depth of implantation.

In some embodiments, at least one face of the substrate is covered before ion implantation with a masking material of varying thickness, to cause the ion implantation to be performed at a varying depth.

One advantage of such a masking pattern is to form an electrode emerging from the substrate. The thickness of the masking material may vary smoothly to avoid sharp changes in the ion implantation depth profile.

In some embodiments, the ion implantation is performed according to a pattern having at least two separate regions, preferentially quadrant regions as to provide position detecting in two dimensions. Preferentially, radiation induced current is sensed from electrodes corresponding to the respective separate regions to give an insight on the position of the beam relatively to these regions. In other embodiments, the position of the beam relatively to a top resistive electrode and/or a bottom resistive electrode may be estimated by measuring the radiation induced current on the lateral sides of the electrodes, and computing the distance between the incident point and each lateral contact using the value of resistance and the dimensions of each electrode.

In some embodiments, the substrate has front and rear faces and at least one side face that extends obliquely relative to the front and rear faces. Preferentially, the substrate has at least a pair of opposite side faces that extend obliquely relative to the front and rear faces. Typically, the masking material, for example a shadow or hard mask, is applied on the front face of the substrate along two opposite edges thereof. The resulting electrode directly emerges from the corresponding opposite side faces of the substrate.

### High temperature annealing

After ion implantation, the substrate and newly formed graphitic electrodes may be annealed at a temperature greater than or equal to 800°C, preferably between 800°C and 1500°C, in inert atmosphere. This optional annealing step helps to further convert the regions damaged by the ions to a graphitic phase and obtain low resistivity layers, while contributing to repair the structural sub-threshold damage that may have arisen in the overlying diamond cap region.

### Electrical connections

In some embodiments, the surface of the substrate is covered at least partially by a masking material after ion implantation, preferentially a hard mask, and is subjected to reactive ion etching through the masking material. The hard mask may be made of aluminum or chromium. The etching process advantageously creates one or more openings to access buried portions of the electrodes. Preferentially, each opening is then filled a metal contact to connect each buried portion of the electrode with an electrical terminal. The metal contact may be made of aluminum, gold, or any other metal suitable for this purpose.

The metal contact may be applied using shadow masks and/or photolithographic techniques. The electrode(s) may be connected to an electrical terminal through any of the faces of the substrate. For instance, the electrodes may be connected directly through the side faces of the substrate, making the use of simple surface mount devices possible for connection to readout electronics. There may be one or more electrical contacts for each electrode, preferentially at least one electrical contact for each top electrode, and at least two electrical contacts for the bottom electrode serving as the bias electrode.

In some embodiments, a conductive resin such as a two-component silver loaded material may be applied on the faces of the substrate to provide an electrical connection to the graphitic electrodes. Additionally, an insulating resin may be applied in some regions of the surface of the substrate, for example the corners, to avoid short circuits between adjacent portions of conductive resin contacting different electrodes.

Exemplary embodiments of the present invention also relate to a radiation detector according to claim 9.

By "homogeneous" it is meant that the structure of the electrode is deprived of the cracks resulting from laser graphitization. The electrode is 2D-continuous.

By "bottom" it is meant that the electrode is situated at the rear face of the substrate or close to it, the bottom electrode being for example at a distance from the rear face of the substrate less than 1/5 of the total thickness of the substrate, while the top electrode may also be at a distance from the front face of the substrate less than 1/5 of the total thickness of the substrate.

The graphitic electrode(s) may have a rectangular cross section, different from the circular cross section observed with laser graphitization. The electrode has a planar configuration.

In some embodiments, the detector comprises at least two adjacent top electrodes embedded within the substrate at a same depth, preferentially quadrant electrodes or stripe-like electrodes.

The at least one graphitic homogeneous electrode may be buried entirely within the substrate. At least one end of the at least one graphitic homogeneous electrode may emerge from the substrate, preferably from at least one of the side faces of the substrate.

In some embodiments, the substrate has a polyhedral shape defining two parallel opposite faces forming, respectively, the front and the rear faces of the substrate, each of the top and rear face having a width different from the width of the other face. The top electrode emerges from a first pair of opposite lateral faces of the substrate and the bottom electrode emerges from a second pair of opposite lateral faces of the substrate different from the ones of the first pair.

Preferentially, the radiation detector is supported by a support such as a printed circuit board. Such support may comprise conductive tracks to which the terminals of the detector are connected. These tracks may be connected to suitable readout electronics, that may be present on the same board or be distant. The readout electronics may comprise a voltage source to apply a voltage between the at one first electrode and the bias electrode, so that the ionizing radiation will generate a charge transfer within the substrate between the electrodes.

The detector may be of the PSD (Position Sensitive Detector) or BPM (Beam Position Monitor) type.

### Beamline

The present invention also relates to a beamline comprising a radiation detector as defined herein, the detector being positioned across the beam, in particular an X-ray beam. In terms of intensity, the detector according to the invention may advantageously intercept at most 5% of the beam. For example, the radiation detector is mounted into a beamline at a light-source facility. It can be used for high intensity (so called "white" beam) beam position monitoring or position detection. The radiation detector according to the invention may also be part of a vacuum window for an X-Ray tube or for an ion beamline.

### Brief description of the figures

Several exemplary embodiments will now be described with reference to the accompanying drawings, in which:
Fig.1 is a simplified schematic representation of a detector mounted in a beamline in accordance with the invention;
Fig.2 is a graph illustrating the principle of ion implantation with an example of two types of ions implanted at different depths within a diamond bulk;
Fig.3 is a schematic and simplified front view (Fig.3a) and rear view (Fig.3b) of a first exemplary embodiment of a detector according to the invention, showing respectively in transparency the top and bottom buried graphitic electrodes;
Fig.4 is a flowchart schematically illustrating some steps of a method for manufacturing the detector of figure 3;
Fig.5 shows in a 3-dimensional view (Figure 5a) and side view (Fig.5b) the detector of Fig.3. during the first step (masking and ion implantation) of the method of Fig.4;
Fig.6 is a side view of the detector of Fig.3 during the second step (optional annealing) of the method of Fig.4;
Fig.7 is a side view of the detector of Fig.3 during the third step (etching) of the method of Fig.4;
Fig.8 is a side view of the detector of Fig.3 during the fourth step (formation of electrical contacts) of the method of Fig.4;
Fig.9 is a simplified schematic front view (Fig.9a) and rear view (Fig.9b) of another embodiment of radiation detector according to the invention having a quadrant electrode configuration;
Fig.10 is a flowchart schematically illustrating a method for manufacturing the detector of Fig.9;
Fig.11 is a 3-dimensional view (Fig.11a) and side view (Fig.11b) of the detector of Fig.9 during the first step (masking and ion implantation) of the method of Fig.10;
Fig.12 is a side view of the detector of Fig.9 during the second step (optional annealing) of the method of Fig.10;
Fig.13 is a side view of the detector of Fig.9 during the third step (etching) of the method of Fig.10;
Fig.14 is a side view of the detector of Fig.9 during the fourth step (formation of electrical contacts) of the method of Fig.10;
Fig.15 is a simplified schematic side view of another embodiment of radiation detector according to the invention, having surface electrodes;
Fig.16 is a flowchart schematically illustrating a method for manufacturing the detector of Fig.15;
Fig.17 is a schematic side view of the detector of Fig.15 during the first step (masking and ion implantation) of the method of Fig.16;
Fig.18 is a schematic side view of the detector of Fig.15 during the second step (optional annealing) of the method of Fig.16;
Fig.19 is a simplified schematic front view of another embodiment of radiation detector according to the invention having side-contacting electrodes;
Fig.20 is a flowchart schematically illustrating a method for manufacturing the detector of Fig.19;
Fig.21 is a side view (Fig.21a) and front view (Fig.21b) of the detector of Fig.19 during the first step (masking and ion implantation) of the method of Fig.20;
Fig.22 is a side view (Fig.22a and Fig.22b) and a front view (Fig.22c) of the detector of Fig.19 during the second step (optional annealing) of the method of Fig.20;
Fig.23 is a simplified schematic front view of an alternative embodiment of radiation detector according to the invention having a quadrant electrode configuration with side contacting;
Fig.24 is a simplified schematic front view of an alternative embodiment of radiation detector according to the invention having a stripe-like electrode configuration;
Fig.25 (already described) is a picture showing the cross section of a graphitic "wire" resulting from laser graphitization, adapted from *"Nanostructured interior of laser-induced wires in diamond."* (Ashikkalieva, K. K., et al. , Diamond and Related Materials 91 (2019): 183-189).;
Fig. 26 (already described) is a picture showing the cross section of a graphitic electrode obtained through a ion implantation process, adapted from *"*Structural transformation of implanted diamond layers during high temperature annealing. " (Rubanov, S., et al. ,Nuclear Instruments and Methods in Physics Research Section B: Beam Interactions with Materials and Atoms 365 (2015): 50-54).

### Detailed description

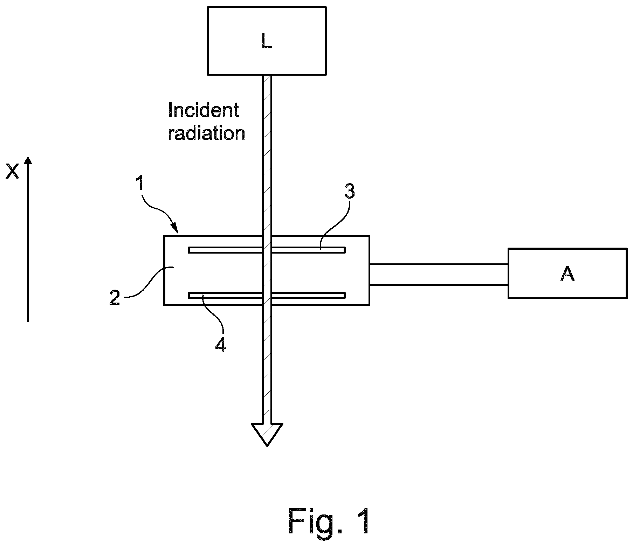

A radiation detector 1 according to the invention is represented in a simplified and schematic manner in Figure 1. The detector 1 is configured to be mounted into a beamline at a light-source facility and used in a manner known per se for position monitoring and/or position detection of an incident radiation emitted by a light source L.

The detector 1 comprises a scCVD diamond substrate 2 and one or more graphitic electrodes 3,4, which are at least partially embedded in the diamond substrate 2, as illustrated in Figure 1. Preferentially, the detector 1 comprises a single bias rear electrode 4 and one or more measurement top electrodes 3, on which the beam impinges.

The detector 1 is connected to any appropriate external read out equipment A for bias supply and measurements of the readout currents.

In the following, the face of the detector facing the light source is designated as "front" or "top" face and its opposing face is designated as "rear" or "bottom" face. Both the front and rear faces are exposed to the incident radiation. All the faces extending from the front to the rear faces, not directly exposed to the incident radiation, are designated as "lateral" or "side" faces. The direction X is orthogonal to the front and rear faces and designated herein as the "thickness direction".

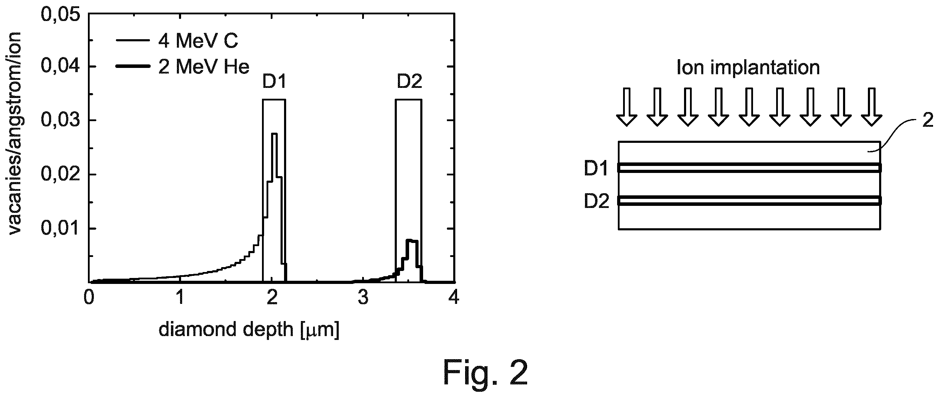

According to the invention, at least one graphitic electrode 3 is formed by ion implantation. Figure 2 illustrates the variable depth at which ions may be implanted depending on their nature and energy. The graph shows for 2 MeV He ions and 4 MeV C ions the damage profiles, given in vacancies created within the diamond bulk 2 by angstrom and by ion, as a function of the diamond depth. The framed regions show the approximate depth interval where the graphitization threshold of the diamond substrate is reached. Depending on the type of ion implanted, the transition from diamond to graphite phase only occurs within a thin layer embedded within the diamond bulk, designated in Figure 2 as "D1" for the 4 MeV C ions and "D2" for the 2 MeV He ions. The diamond layer overlying the framed region is left relatively undamaged. Hence, it is possible to control the depth at which the electrode 3 can be buried within the substrate 2 by choosing the type of ion that is implanted.

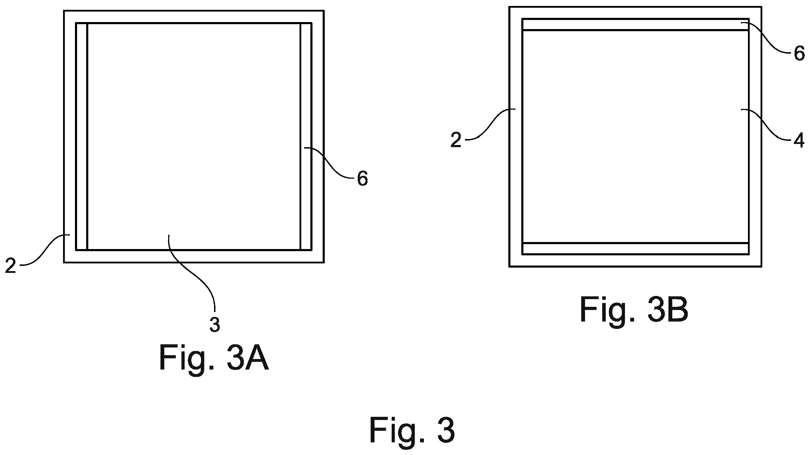

A first embodiment of a radiation detector 1 according to the invention is shown in Figure 3. In the example considered, the detector 1 comprises one rectangular top electrode 3 and one rectangular bias electrode 4 which are entirely buried within the substrate 2. Connection to electrical terminals is provided to the electrodes 3 and 4 through metal contacts 6, which extend along two opposite sides of the electrodes 3 and 4.

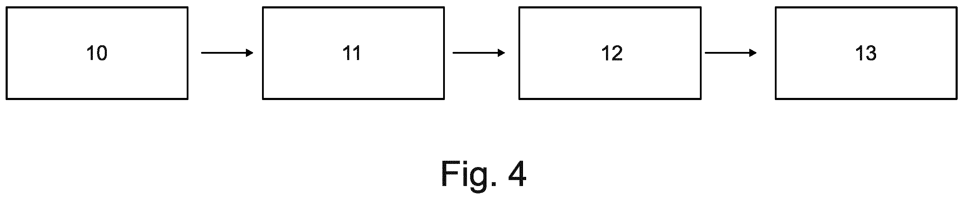

An exemplary method to manufacture the detector 1 illustrated in Figure 3 is represented by the flowchart of Figure 4. The method comprises four steps for which a more detailed description is given below: a masking of the substrate and ion implantation step 10, an optional annealing step 11, a reactive ion etching step 12 and an electrical contacting step 13. Before starting the process of manufacturing the detector 1, the diamond substrate is usually cleaned in usual manner through hot acid treatment.

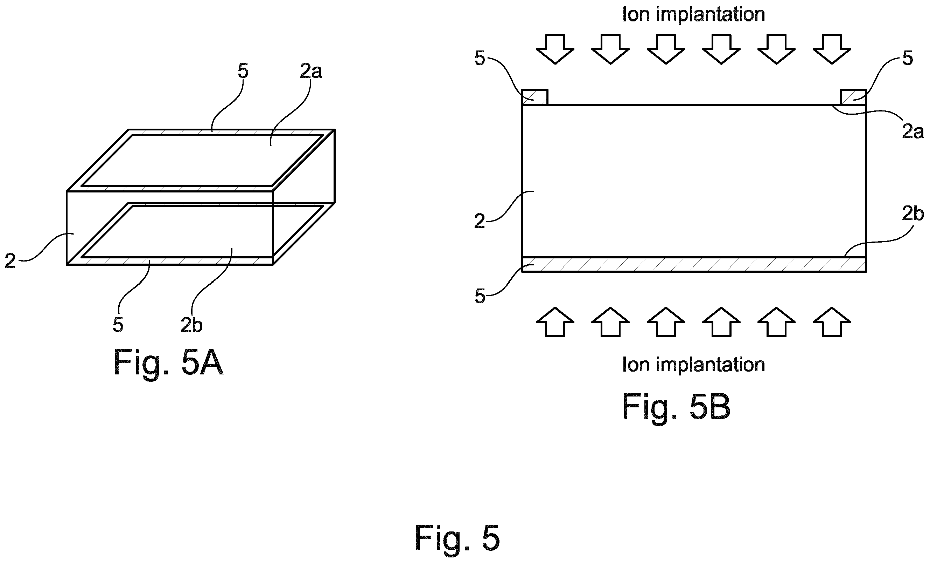

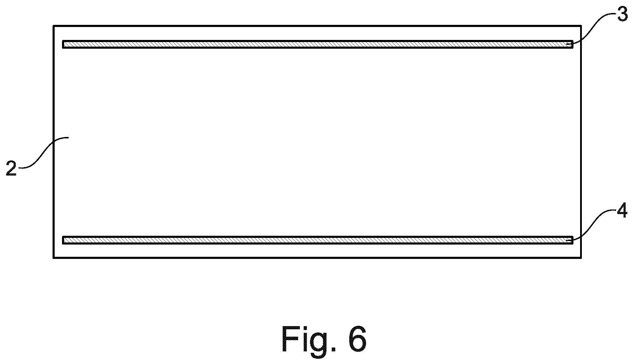

At step 10, as illustrated in Figure 5a, a masking material 5, preferentially a shadow or hard mask, is applied on the contours of the front face 2a and on the rear face 2b of the substrate 2. The substrate 2 is then implanted through the masking material 5 across both the front 2a and rear 2b faces, as shown in Figure 5b, with the ions being prevented to penetrate within the bulk diamond 2 in the regions covered with the masking material 5. In the example considered and because of the selected masking pattern, both the top electrode 3 and the bias electrode 4 resulting from the ion implantation process are each completely buried into the substrate 2, as illustrated on Figure 6. The electrodes 3 and 4 are planar and 2D-continuous, meaning they extend without cracks along the two directions orthogonal to the thickness direction. The electrodes 3 and 4 are of rectangular or square shape and of relatively small thickness.

After ion implantation, at step 11, the substrate 2 and graphitic electrodes 3 and 4 may be subjected to an optional high temperature annealing, to help the diamond layer overlying the electrodes 3 to recover from potential sub-threshold damage incurred during ion implantation, among other reasons.

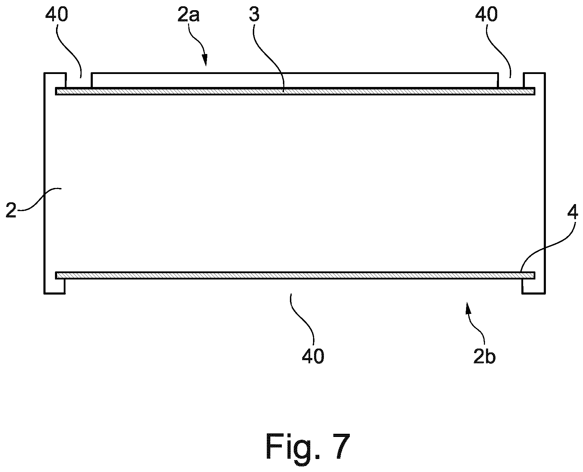

Since the electrodes 3 and 4 are completely embedded within the substrate 2, openings 40 are created at step 13 to connect the electrodes 3 and 4 to electrical terminals as shown in Figure 7. The openings 40 may be obtained by reactive ion etching through a hard mask, preferentially made of aluminum or chromium, that is applied on the substrate 2 beforehand. Alternatively, or additionally, the surface of the substrate 2 to be etched may also be patterned with a photolithographic method. Four stripe-like openings 40 are created in the diamond substrate 2, two on the front face 2a and two on the rear face 2b. Two openings 40 extend along two opposite sides of the electrode 3 buried underneath the front face 2a, and two openings 40 extend along two opposite sides of the electrode 4 underneath the rear face 2b.

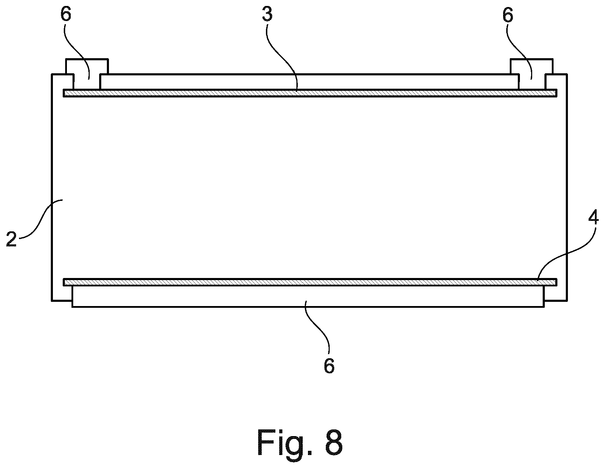

At final step 14 and as illustrated in Figure 8, metal contacts 6, for example aluminum or gold contacts, are deposited in the newly created openings 40, using for example shadow masks and/or photolithographic process. In the example considered, the radiation detector is a position sensing detector (PSD). The electrodes are resistive and the position of the beam relatively to the top and the bottom electrodes may be estimated by measuring the radiation induced current at the four metal contacts 6 and computing the distance between the incident point and each lateral metal contact 6 based on the resistance and the dimensions of each electrode.

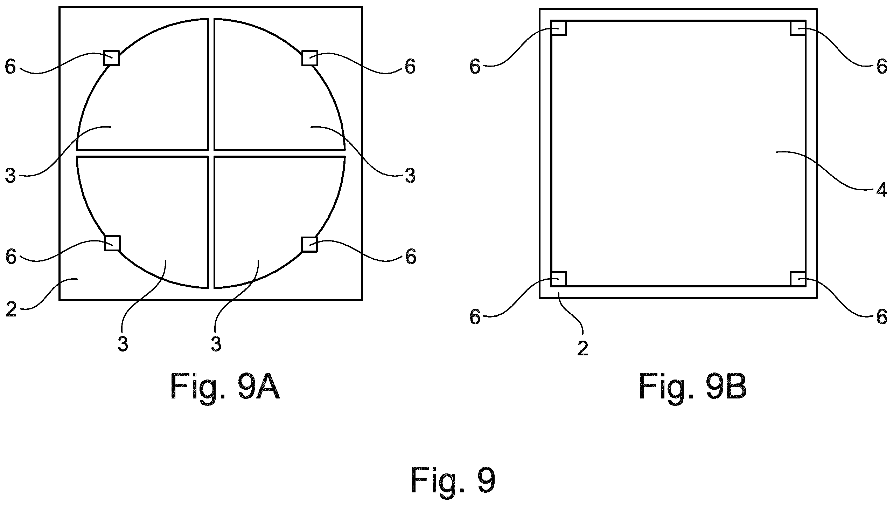

The variant detector 1 of Figure 9 comprises four separate quadrant top electrodes 3, located beneath the front face 2a of the substrate 2 and a square bottom bias electrode 4, located beneath the rear face of the substrate 2. In each quadrant electrode 3, a surface electrical contact 6 is connecting the buried electrode 3 to the external surface of the substrate. Four additional electrical contacts 6 are provided in the four corners of the bias electrode 4.

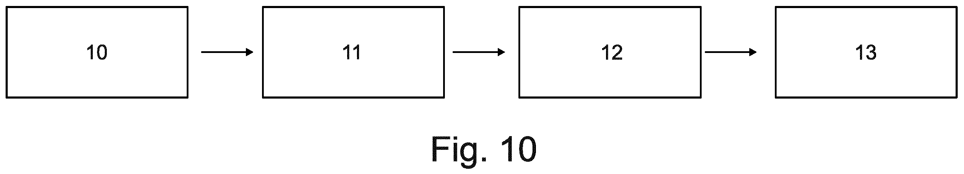

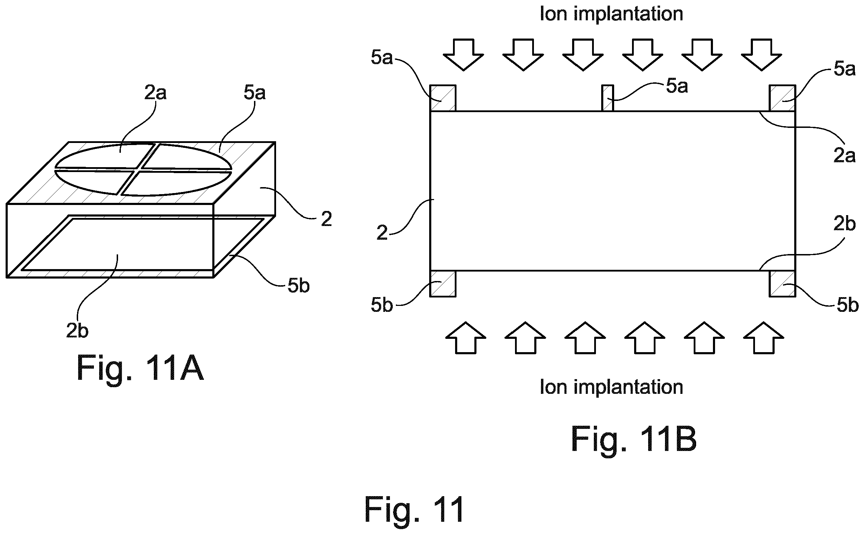

Such a detector 1 may be obtained with the method illustrated in Figure 10 and detailed in Figures 11-14, which show a side view of the radiation detector 1 during the manufacturing process. The fabrication process comprises a masking of the substrate and ion implantation step 10, an optional annealing step 11, a reactive ion etching step 12 and an electrical contacting step 13.

First, at step 10, and as illustrated in Figure 11a, the front face 2a of the substrate 2 is covered with a masking material 5a forming a pattern having four separate quadrant regions, each quadrant being in this example a circular sector of central angle 90°. Because of the fine structural pattern needed for this type of electrode configuration, is it preferable to use a hard mask combined with lithographic technique for the masking step. A masking material 5b is covering the contours of the rear face 2b of the substrate.

Figure 11b shows the process of ion implantation through the masking material 5a and 5b across both the front 2a and the rear 2b faces. During step 10, the ions are prevented from penetrating into the bulk diamond 2 in the regions covered with the masking material 5a and 5b.

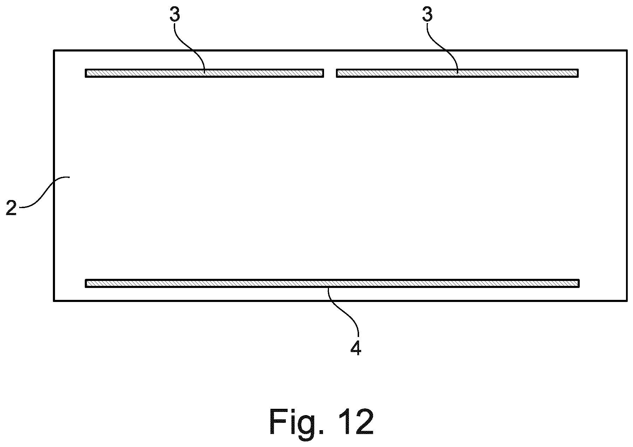

The graphitic electrodes 3 and 4 obtained following ion implantation are shown in Figure 12. They are planar, 2D-continuous and each completely buried within the substrate 2. The quadrant electrodes 3 are separated by a relatively small gap ensuring isolation between the electrodes while keeping a good resolution for position detecting. At this step 11, the sample comprising the substrate 2 and the electrodes 3 and 4 may be subjected to high temperature annealing, as described above.

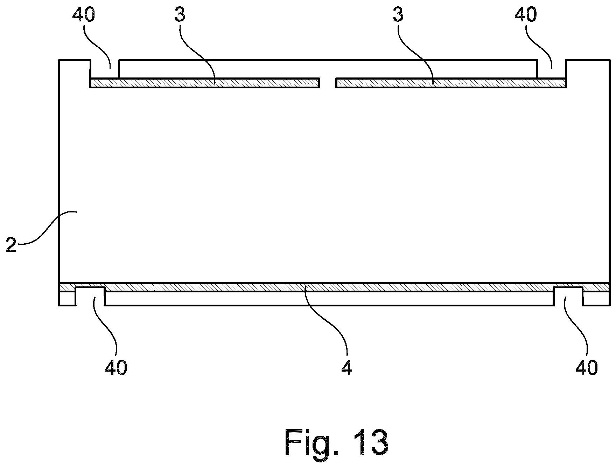

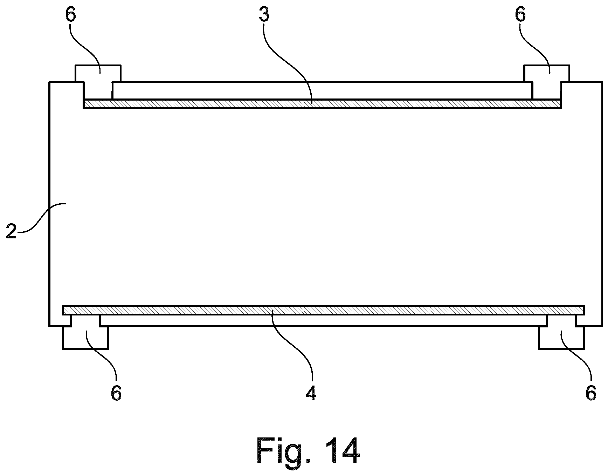

As illustrated in Figure 13, openings 40 are created at step 12 to connect each quadrant electrode 3 to an electrical terminal, and to connect the bias electrode 4 at four distinct spots corresponding to each of its corners. The openings 40 are then filled at step 13 with metal contacts 6, as shown in Figure 14.

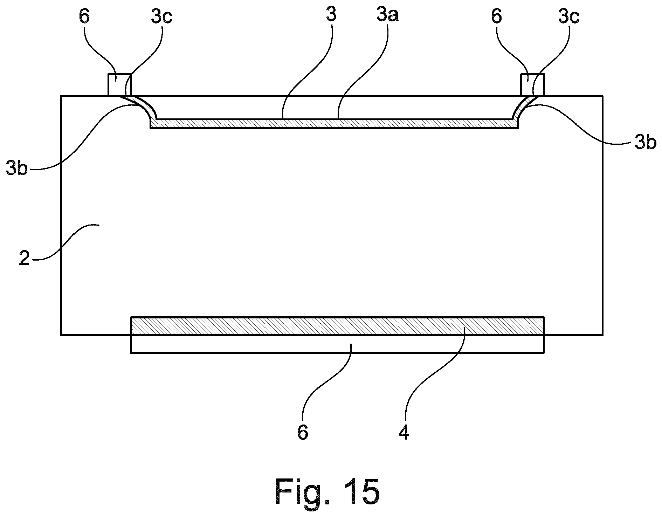

Another embodiment of a radiation detector 1 according to the invention is shown in Figure 15 in simplified and schematic manner. In this example the detector 1 comprises a top electrode 3 comprising a flat buried central portion 3a, two emerging ends 3c and curved portion 3b connecting the buried central portion 3a to the emerging ends 3c. The interconnecting portion 3b exhibits a relatively smooth curvature which can be likened to that of an arc of a circle. The detector also comprises a bias electrode 4 embedded within the substrate 2. The electrode 4 is connected to external electrical terminals through a stripe-like or square metal contact 6.

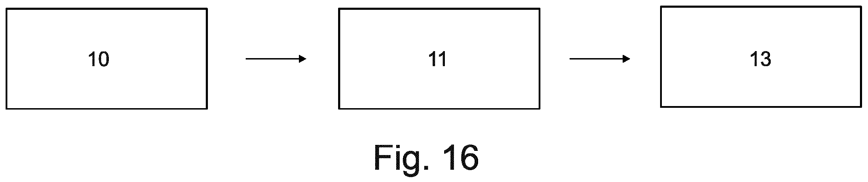

The detector 1 shown in Figure 15 can be manufactured following the method illustrated by the flowchart of Figure 16, having a masking and ion implantation step 10, an optional annealing step 11 and an electrical contacting step 13.

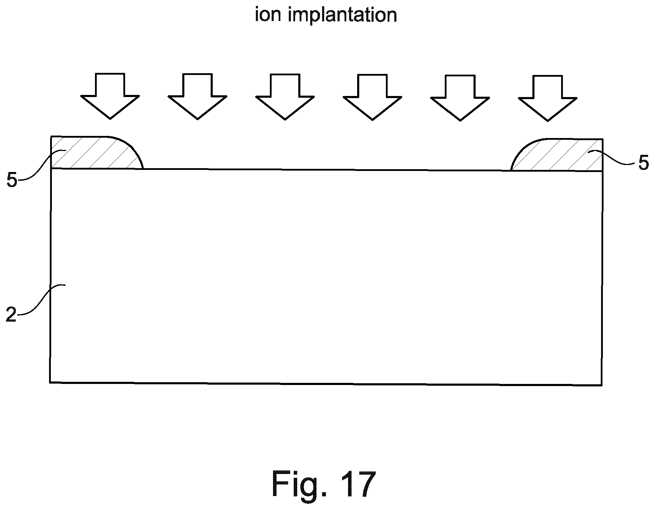

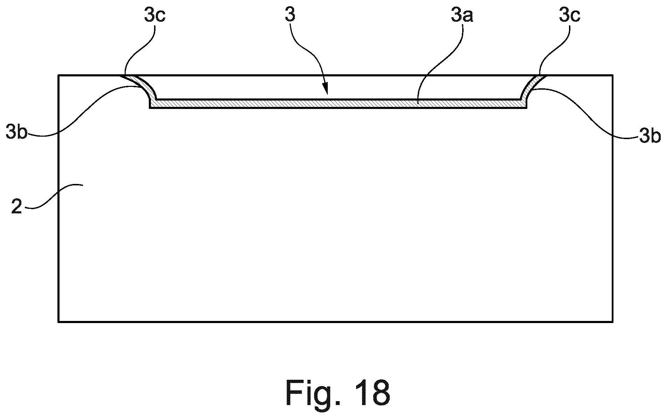

As shown in Figure 17, a masking material 5 of varying thickness is applied on the front face of the substrate 2 to modulate the penetration depth of the ion during the implantation. The resulting 2D-continuous electrode 3 is shown in Figure 18. In the central region that was not covered by the masking material 5, the central portion 3a of the electrode 3 is buried at constant thickness within the substrate 2. As the thickness of the masking material 5 increases, the curved portion 3b of the electrode 3 gets closer to the surface of the substrate 2, up to its endpoints 3c where it emerges from the substrate 2. In this example, there is no need for the front surface to be etched to reach the electrode 3; metal contacts 6 can be directly deposited on the front surface 2a, where the electrode 3 emerges from the substrate.

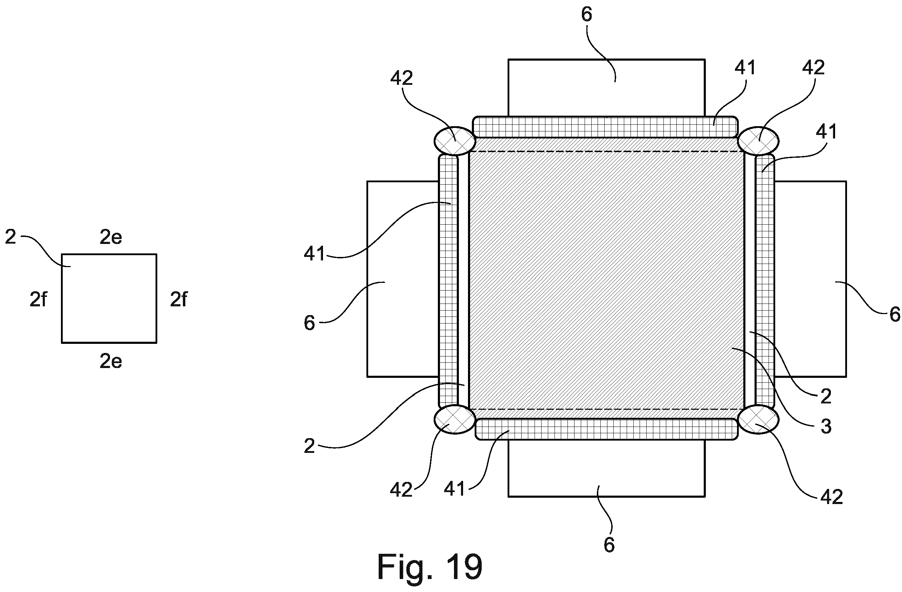

Figure 19 shows another embodiment where the detector 1 comprises one top rectangular electrode 3 and one bottom electrode 4 (not represented here), each electrode extending from a lateral face of the substrate 2 to the opposite lateral face. The substrate 2 defines a first pair of opposite lateral faces 2e on which the top electrode emerges from the substrate and a second pair of opposite lateral faces 2f on which the bottom electrode emerges from the substrate.

A conductive resin 41 is applied on each of the lateral faces. Optionally, an insulating resin 42 may be applied in the corners of the substrate 2, to avoid short circuits between adjacent portions of the conductive resin 41 contacting the electrodes 3 and 4.

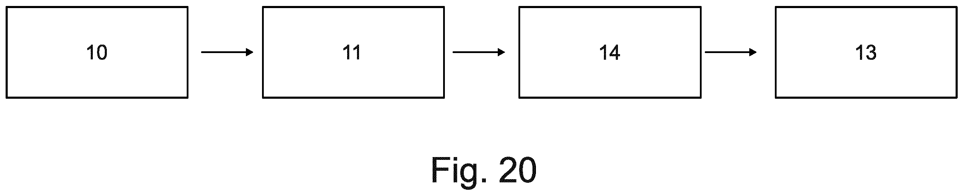

An exemplary method to manufacture such a detector is schematically represented by the flowchart in Figure 20. The method comprises a masking and ion implantation step 10, an optional annealing step 11, a conductive resin application step 14, and an electrical contacting step 13.

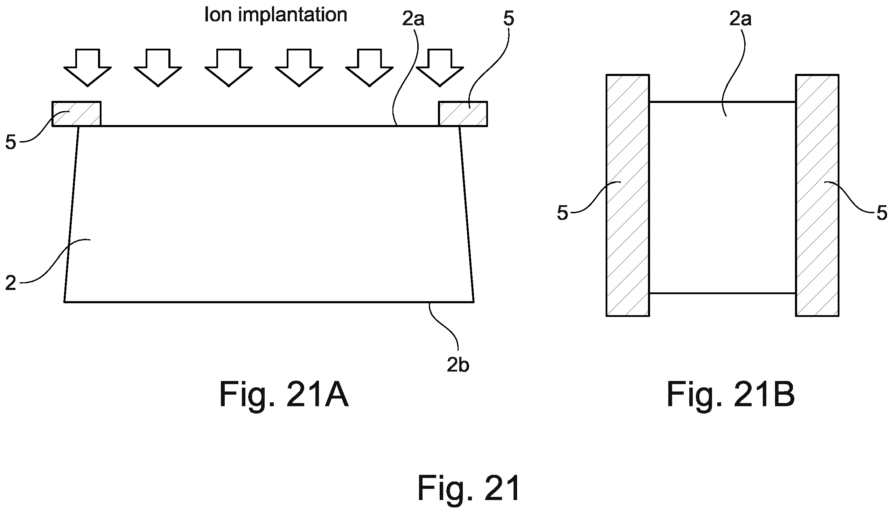

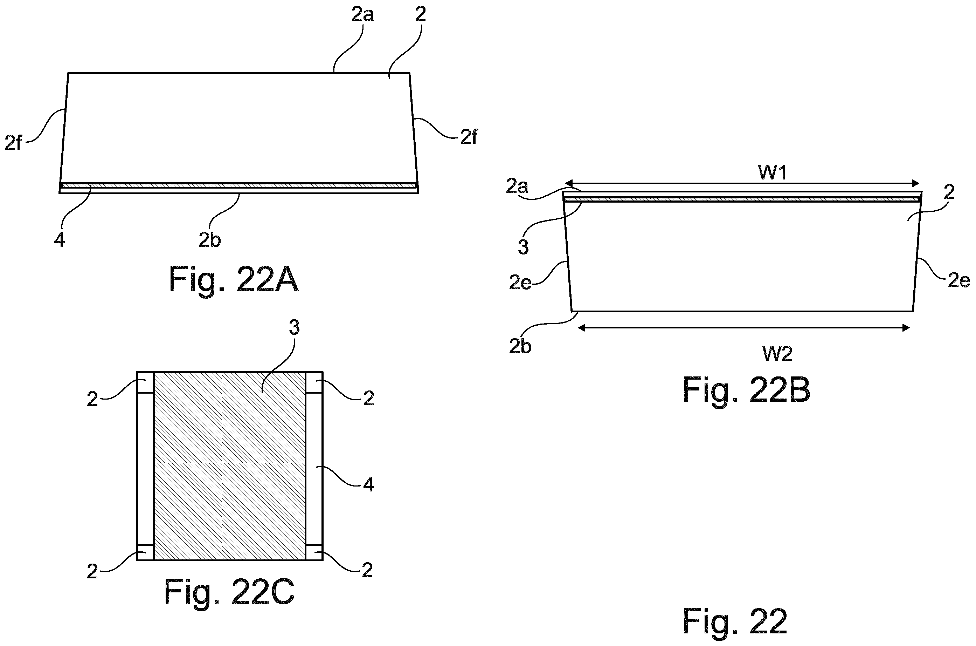

In this example, the substrate 2 has a polyhedral shape, each lateral face being trapezoidal and the front face 2a et rear face 2b being rectangular. A band of masking material 5 is applied along the opposite sides of the front face 2a of the substrate 2 as shown in Figures 20a and 21b. A similar masking pattern is applied to the rear face 2b of the substrate 2 (not shown here). The graphitic electrodes 3 and 4 resulting from the ion implantation across the front face 2a and rear face 2b each emerge on two opposite lateral faces of the substrate 2 as shown in Figure 22. The electrode 3 obtained through ion implantation across the rear face 2b of the substrate 2 emerges from a first pair of lateral faces 2e. The electrode 4 obtained through ion implantation across the front face 2a of the substrate 2 emerges from a second pair of lateral faces 2f.

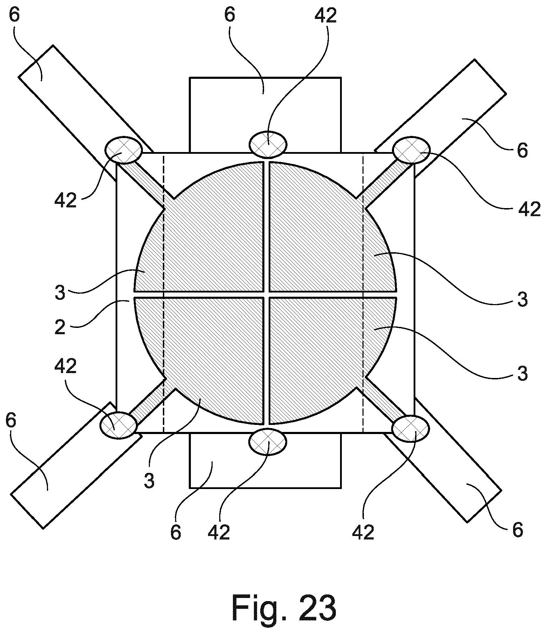

Other embodiments of radiation detectors according to the invention are shown in Figures 23-24. Figure 23 illustrates a detector comprising four embedded separate quadrant electrodes 3 emerging to the corner edges of the substrate 2. The bias electrode 4 is located beneath the rear surface of the substrate 2 and is not represented here. An insulating resin 42 is applied at several points on the substrate 2 to avoid short circuits and electrical contacts 6 are deposited directly on the lateral faces of the substrate 2.

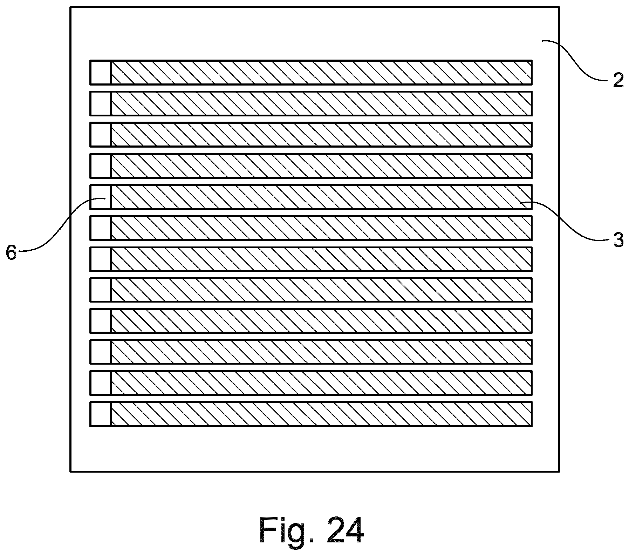

Alternatively, as shown in Figure 24, the top electrodes 3 may be arranged as an array of stripe-like buried electrodes, with an electrical contact 6 provided for each of the stripe electrode.

The above examples merely illustrate possible embodiments of various aspects of the present disclosure and are not intended to be limiting; other aspects and embodiments will be apparent to those skilled in the art. For instance, the possibilities for electrode patterning are not limited to the ones described above. The detector may comprise one or more electrode of any shape, for example a circular sector that is not a quadrant, or several polygonal separate regions, or a combination of several patterns of various shapes.

## Claims

1. A method for manufacturing a radiation detector (1) comprising:
- providing a substrate (2) comprising a single-crystal diamond,
- forming at least one first planar graphitic electrode (3) at least partially embedded within the substrate (2) by ion implantation, wherein the first electrode (3) is covered by diamond substrate on both sides in the thickness direction,
- connecting the first electrode (3) with a least one electrical terminal,
- forming at least one second planar graphitic electrode (4) by ion implantation, the second electrode being at least partially embedded within the substrate (2)
**characterized in that** the second planar graphitic electrode (4) is formed at a depth from a horizontal plane different from a depth from the same plane of the first electrode (3).

2. The method according to claim 1, wherein the surface of the substrate (2) is at least partially covered with a masking material (5) prior to the ion implantation, the masking material (5) preventing at least partially the ions from penetrating into the substrate during ion implantation and/or modifying the depth of implantation.

3. The method according to any one of claims 1 and 2, wherein at least one face of the substrate is covered before ion implantation with a masking material (5) of varying thickness, to cause the ion implantation to be performed at a varying depth.

4. The method according to any one of the preceding claims, wherein the ion implantation is performed according to a pattern having at least two separate regions, preferentially quadrant regions.

5. The method according to any one of claims 1 to 4, wherein the substrate (2) has a front (2a) and a rear (2b) face and at least one side face (2e,2f) that extends obliquely relative to the front and rear faces.

6. The method according to any of the preceding claims, the at least one first electrode (3) having a shape selected among polygonal, preferably rectangular or square, circular sector, preferably quadrant, or stripe-like.

7. The method according to any of the preceding claims, wherein the substrate (2) and graphitic electrode(s) (3,4) are annealed after ion implantation.

8. The method according to any of the preceding claims, wherein the surface of the substrate (2) is covered at least partially by a masking material (5) after ion implantation, preferentially a hard mask, and is subjected to reactive ion etching through the masking material.

9. A radiation detector comprising:
- a substrate (2) comprising a single-crystal diamond,
- at least one graphitic homogeneous planar top electrode (3) at least partially embedded within the substrate (2), wherein the planar top electrode (3) is covered by diamond substrate on both sides in the thickness direction,
- at least one homogeneous graphitic planar bottom electrode (4) at least partially embedded within the substrate (2),
**characterized in that** the planar bottom electrode (4) is formed at a depth from a horizontal plane different from a depth from the same plane of the top electrode (3).

10. The detector according to claim 9, comprising at least two adjacent top electrodes (3) embedded within the substrate (2) at a same depth, preferentially quadrant electrodes or stripe-like electrodes.

11. The detector according to any one of claims 9 and 10, at least one end (3c) of the at least one graphitic homogeneous top electrode (3) emerging from the substrate (2), preferably from at least one of the side faces of the substrate.

12. The detector according to any one of claims 9 to 11,
- the substrate (2) having a polyhedral shape defining two parallel opposite faces forming, respectively, the front (2a) and the rear (2b) faces of the substrate, each of the front (2a) and rear (2b) face having a width (W1) different from the width (W2) of the other face,
- the top electrode (3) emerging from the substrate (2) at a first pair (2e) of opposite lateral faces of the substrate,
- the bottom electrode (4) emerging from the substrate (2) at a second pair (2f) of opposite lateral faces of the substrate different from the ones of the first pair (2e).

13. A beamline comprising a detector (1) as defined in any one of claims 9 to 12, the detector (1) being positioned across the beam, preferentially as to intercept not more than 5% of the beam in terms of intensity.

## Patentansprüche

1. Verfahren zum Herstellen eines Strahlungsdetektors (1), welches Folgendes umfasst:
- Bereitstellen eines Substrats (2), das einen einkristallinen Diamanten umfasst,
- Bilden wenigstens einer ersten planaren Graphitelektrode (3), die wenigstens teilweise innerhalb des Substrats (2) eingebettet ist, durch Ionenimplantation, wobei die erste Elektrode (3) auf beiden Seiten in der Dickenrichtung durch das Diamantsubstrat bedeckt ist,
- Verbinden der ersten Elektrode (3) mit wenigstens einem elektrischen Anschluss,
- Bilden wenigstens einer zweiten planaren Graphitelektrode (4) durch Ionenimplantation, wobei die zweite Elektrode wenigstens teilweise innerhalb des Substrats (2) eingebettet ist, **dadurch gekennzeichnet, dass** die zweite planare Graphitelektrode (4) in einer Tiefe von einer horizontalen Ebene gebildet ist, die sich von einer Tiefe der ersten Elektrode (3) von der gleichen Ebene unterscheidet.

2. Verfahren nach Anspruch 1, wobei die Oberfläche des Substrats (2) vor der Ionenimplantation wenigstens teilweise mit einem Maskierungsmaterial (5) bedeckt ist, wobei das Maskierungsmaterial (5) wenigstens teilweise verhindert, dass die Ionen während einer Ionenimplantation in das Substrat eindringen, und/oder die Implantationstiefe modifiziert.

3. Verfahren nach einem der Ansprüche 1 und 2, wobei wenigstens eine Fläche des Substrats vor einer Ionenimplantation mit einem Maskierungsmaterial (5) variierender Dicke bedeckt wird, um zu bewirken, dass die Ionenimplantation mit einer variierenden Tiefe durchgeführt wird.

4. Verfahren nach einem der vorhergehenden Ansprüche, wobei die Ionenimplantation gemäß einem Muster mit wenigstens zwei separaten Gebieten, vorzugsweise Quadrantengebieten, durchgeführt wird.

5. Verfahren nach einem der Ansprüche 1 bis 4, wobei das Substrat (2) eine vordere (2a) und eine hintere (2b) Fläche und wenigstens eine Seitenfläche (2e,2f) aufweist, die sich relativ zu der vorderen und hinteren Fläche schräg erstreckt.

6. Verfahren nach einem der vorhergehenden Ansprüche, wobei die wenigstens eine erste Elektrode (3) eine Form aufweist, die unter polygonal, vorzugsweise rechteckig oder quadratisch, einem Kreissektor, vorzugsweise einem Quadranten, oder streifenförmig ausgewählt ist.

7. Verfahren nach einem der vorhergehenden Ansprüche, wobei das Substrat (2) und die Graphitelektrode(n) (3,4) nach einer Ionenimplantation getempert werden.

8. Verfahren nach einem der vorhergehenden Ansprüche, wobei die Oberfläche des Substrats (2) nach einer Ionenimplantation wenigstens teilweise durch ein Maskierungsmaterial (5), vorzugsweise eine Hartmaske, bedeckt wird und reaktivem Ionenätzen durch das Maskierungsmaterial unterzogen wird.

9. Strahlungsdetektor, der Folgendes umfasst:
- ein Substrat (2), das einen einkristallinen Diamanten umfasst,
- wenigstens eine homogene planare obere Graphitelektrode (3), die wenigstens teilweise innerhalb des Substrats (2) eingebettet ist, wobei die planare obere Elektrode (3) auf beiden Seiten in der Dickenrichtung durch das Diamantsubstrat bedeckt ist,
- wenigstens eine homogene planare untere Graphitelektrode (4), die wenigstens teilweise innerhalb des Substrats (2) eingebettet ist, **dadurch gekennzeichnet, dass** die planare untere Elektrode (4) in einer Tiefe von einer horizontalen Ebene gebildet ist, die sich von einer Tiefe der oberen Elektrode (3) von der gleichen Ebene unterscheidet.

10. Detektor nach Anspruch 9, der wenigstens zwei angrenzende obere Elektroden (3) umfasst, die innerhalb des Substrats (2) in einer gleichen Tiefe eingebettet sind, vorzugsweise Quadrantenelektroden oder streifenartige Elektroden.

11. Detektor nach einem der Ansprüche 9 und 10, wobei wenigstens ein Ende (3c) der wenigstens einen homogenen oberen Graphitelektrode (3) aus dem Substrat (2), vorzugsweise aus wenigstens einer der Seitenflächen des Substrats, austritt.

12. Detektor nach einem der Ansprüche 9 bis 11,
- wobei das Substrat (2) eine polyedrische Form aufweist, die parallele gegenüberliegende Flächen definiert, die die vordere (2a) bzw. die hintere (2b) Fläche des Substrats bilden, wobei jede der vorderen (2a) und hinteren (2b) Fläche eine Breite (W1) aufweist, die sich von der Breite (W2) der anderen Fläche unterscheidet,
- wobei die obere Elektrode (3) an einem ersten Paar (2e) gegenüberliegender lateraler Flächen des Substrats aus dem Substrat (2) austritt,
- die untere Elektrode (4), die aus dem Substrat (2) an einem zweiten Paar (2f) gegenüberliegender lateraler Flächen des Substrats austritt, die sich von denen des ersten Paars (2e) unterscheiden.

13. Strahllinie, die einen Detektor (1) nach einem der Ansprüche 9 bis 12 umfasst, wobei der Detektor (1) über den Strahl hinweg positioniert ist, vorzugsweise so, dass er nicht mehr als 5 % des Strahls in Bezug auf die Intensität abfängt.

## Revendications

1. Procédé de fabrication d'un détecteur de rayonnements (1) comprenant :
- la fourniture d'un substrat (2) comprenant un diamant monocristallin,
- la formation d'au moins une première électrode graphitique plane (3) intégrée au moins partiellement dans le substrat (2), par implantation ionique la première électrode (3) étant recouverte d'un substrat de diamant de part et d'autre dans la direction d'épaisseur,
- la connexion de la première électrode (3) avec au moins une borne électrique,
- la formation d'au moins une deuxième électrode graphitique plane (4) par implantation ionique, la deuxième électrode étant intégrée au moins partiellement dans le substrat (2), **caractérisé en ce que** la deuxième électrode graphitique plane (4) est formée à une profondeur à partir d'un plan horizontal différente d'une profondeur à partir de ce même plan de la première électrode (3).

2. Procédé selon la revendication 1, la surface du substrat (2) étant au moins partiellement recouverte d'un matériau de masquage (5) avant l'implantation ionique, le matériau de masquage (5) empêchant au moins partiellement les ions de pénétrer dans le substrat pendant l'implantation ionique et/ou modifiant la profondeur d'implantation.

3. Procédé selon l'une quelconque des revendications 1 et 2, au moins une face du substrat étant recouverte avant l'implantation ionique d'un matériau de masquage (5) d'épaisseur variable, pour provoquer l'implantation ionique à une profondeur variable.

4. Procédé selon l'une quelconque des revendications précédentes, l'implantation ionique étant réalisée selon un motif ayant au moins deux régions séparées, de préférence des régions en quart de cercle.

5. Procédé selon l'une quelconque des revendications 1 à 4, le substrat (2) ayant une face avant (2a) et une face arrière (2b) et au moins une face latérale (2e, 2f) qui s'étend obliquement par rapport aux faces avant et arrière.

6. Procédé selon l'une quelconque des revendications précédentes, l'au moins une première électrode (3) ayant une forme choisie parmi un secteur circulaire polygonal, de préférence rectangulaire ou carré, de préférence un secteur en quart de cercle ou en forme de bande.

7. Procédé selon l'une quelconque des revendications précédentes, le substrat (2) et la ou les électrodes graphitiques (3, 4) étant recuits après implantation ionique.

8. Procédé selon l'une quelconque des revendications précédentes, la surface du substrat (2) étant recouverte au moins partiellement par un matériau de masquage (5) après implantation ionique, de préférence un masque dur, et étant soumise à une gravure ionique réactive à travers le matériau de masquage.

9. Détecteur de rayonnements comprenant :
- un substrat (2) comprenant un diamant monocristallin,
- au moins une électrode supérieure plane homogène graphitique (3) intégrée au moins partiellement dans le substrat (2), l'électrode supérieure plane (3) étant recouverte d'un substrat de diamant des deux côtés dans la direction d'épaisseur,
- au moins une électrode inférieure plane graphitique homogène (4) intégrée au moins partiellement dans le substrat (2), **caractérisé en ce que** l'électrode inférieure plane (4) est formée à une profondeur à partir d'un plan horizontal différente de la profondeur à partir de ce même plan de l'électrode supérieure (3).

10. Détecteur selon la revendication 9, comprenant au moins deux électrodes supérieures adjacentes (3) intégrées dans le substrat (2) à une même profondeur, de préférence des électrodes en quart de cercle ou des électrodes en forme de bande.

11. Détecteur selon l'une quelconque des revendications 9 et 10, au moins une extrémité (3c) de l'au moins une électrode supérieure homogène graphitique (3) émergeant du substrat (2), de préférence d'au moins une des faces latérales du substrat.

12. Détecteur selon l'une quelconque des revendications 9 à 11,
- le substrat (2) ayant une forme polyédrique définissant deux faces opposées parallèles formant respectivement les faces avant (2a) et arrière (2b) du substrat, chacune des faces avant (2a) et arrière (2b) ayant une largeur (W1) différente de la largeur (W2) de l'autre face,
- l'électrode supérieure (3) émergeant du substrat (2) au niveau d'une première paire (2e) de faces latérales opposées du substrat,
- l'électrode inférieure (4) émergeant du substrat (2) au niveau d'une deuxième paire (2f) de faces latérales opposées du substrat différentes de celles de la première paire (2e).

13. Ligne de faisceau comprenant un détecteur (1) tel que défini selon l'une quelconque des revendications 9 à 12, le détecteur (1) étant positionné en travers du faisceau, de préférence de manière à intercepter au plus 5 % du faisceau en intensité.
